# EUROPEAN PATENT APPLICATION

(11) **EP 4 675 411 A1**
(43) Date of publication of application: **07.01.2026**
(21) Application number: 24306137.1
(22) Date of filing: 05.07.2024
(51) Int. Cl.: G06F 3/04815, G06F 3/04845, G06F 30/12, G06T 19/20, G06F 3/04886

(54) **ANNOTATING A 3D MODELED OBJECT REPRESENTING A CAD MECHANICAL PART OR ASSEMBLY OF PARTS**

(71) Applicant: Dassault Systèmes, 78140 Vélizy-Villacoublay (FR)
(72) Inventor: GAUNET, Dominique, VELIZY VILLACOUBLAY (FR); SERVANT, Bruno, VELIZY VILLACOUBLAY (FR); ARCHIER, Julie, VELIZY VILLACOUBLAY (FR)
(74) Representative: Bandpay & Greuter

(57) **Abstract**

The disclosure notably relates to a computer-implemented method for annotating a 3D modeled object representing a CAD mechanical part or assembly of parts, two or more views of the 3D modeled object being displayed and at least one of the views being compliant with a view of a technical drawing. The method comprises obtaining a 3D scene and displaying an orientation-free view of the 3D modeled object, at least one fixed view of the 3D modeled object. The method also comprises creating, upon user action, an annotation by selecting at least one geometrical element on at least one of the views of the 3D modeled object and an annotation type. The method further comprises displaying the created annotation on at least the orientation-free view.

## Description

### TECHNICAL FIELD

The disclosure relates to the field of computer programs and systems, and more specifically to a method, system and program for annotating a 3D modeled object representing a CAD mechanical part or assembly of parts.

### BACKGROUND

A number of systems and programs are offered on the market for the design, the engineering and the manufacturing of objects. CAD is an acronym for Computer-Aided Design, e.g. it relates to software solutions for designing an object. CAE is an acronym for Computer-Aided Engineering, e.g. it relates to software solutions for simulating the physical behavior of a future product. CAM is an acronym for Computer-Aided Manufacturing, e.g. it relates to software solutions for defining manufacturing processes and operations. In such computer-aided design systems, the graphical user interface plays an important role as regards the efficiency of the technique. These techniques may be embedded within Product Lifecycle Management (PLM) systems. PLM refers to a business strategy that helps companies to share product data, apply common processes, and leverage corporate knowledge for the development of products from conception to the end of their life, across the concept of extended enterprise. The PLM solutions provided by Dassault Systèmes (under the trademarks CATIA, ENOVIA and DELMIA) provide an Engineering Hub, which organizes product engineering knowledge, a Manufacturing Hub, which manages manufacturing engineering knowledge, and an Enterprise Hub which enables enterprise integrations and connections into both the Engineering and Manufacturing Hubs. All together the system delivers an open object model linking products, processes, resources to enable dynamic, knowledge-based product creation and decision support that drives optimized product definition, manufacturing preparation, production and service.

Within these CAD/CAE/CAM systems are known applications that are used to annotate the designed product. The purpose of the annotations is to prepare the designed product for the production. Annotations thus allows the manufacturing of the designed product: the annotated designed product can be directly used for the production of the mechanical part or assembly of parts it represents. Hence, the annotations define and/or present information about the definition of the product for manufacturing, inspections and sustainment. This includes (but is not limited to) data such as exact or simplified geometric shape of the product, supplemental geometry, dimensions, geometrical tolerances, surface textures, surface treatments, weld symbols, material specifications, annotations and symbols. These are also known as Product Manufacturing and Information (PMIs). PMIs thus serve all the industries that manufacture physical products, but also provides support for technical drawing and geometrical product specifications standards; for example like the ones proposed by ISO - International Organization for Standardization, ASME-American Society of Mechanical Engineers and JIS - Japanese Industrial Standard.

Among these applications for annotating, is known a 3D Tolerancing & Annotation application that proposes a 3D definition of the annotations with a correct 3D presentation. However, associated 2D layout presentation could not be correct and not edition is possible.

Is also known a 2D Layout for 3D Design application that proposes a 2D definition of the annotations with a correct 2D presentation. However, the representation of the annotation in 3D is not always correct, their manipulation is not possible in 3D environment, nor their edition.

In addition, when using both application, there is a mere basic synchronization between these 2D and 3D environments, with no possibility to interact with this visualization on both sides at the same time. Hence, there are no direct communications between the 3D definition used for the digital mockup validation of the product that comprises nominal 3D geometry and some technological specifications, but no geometrical tolerances, and the 2D drawing definition used to manufacture the product and that comprises 2D geometry with all explicit dimensions, all geometrical tolerances, all technological specifications (notes, symbols, tables...). Consequently, what will be manufactured is not what has been validated with the digital mockup so that inconsistencies between the two definitions (the definition in 3D and the specification in 2D).

Within this context, there is still a need for an improved method for annotating a 3D modeled object representing a CAD mechanical part or assembly of parts, where at least one of view of the 3D modeled object is compliant with a view of a technical drawing. The designer needs to be offered the possibility to annotate easily, precisely the 3D mockup (that is, the 3D modeled object) and obtain a final 2D presentation at the same time.

### SUMMARY

It is therefore provided a computer-implemented method for annotating a 3D modeled object representing a CAD mechanical part or assembly of parts, two or more views of the 3D modeled object being displayed and at least one of the views being compliant with a view of a technical drawing. The method comprises:
- obtaining a 3D scene and displaying:
   -- an orientation-free view of the 3D modeled object;
   -- at least one fixed view of the 3D modeled object;
- creating, upon user action, an annotation by selecting at least one geometrical element on at least one of the views of the 3D modeled object and an annotation type;
- displaying the created annotation on at least the orientation-free view.

The method may comprise one or more of the following:
- transferring the created annotation on at least one of the other views of the 3D modeled object;
- displaying the annotation on the at least one of the other views of the 3D modeled object, the at least one of the other views of the 3D modeled object being a fixed view of the 3D modeled object, preferably the displaying the annotation on the at least one of the other views of the 3D modeled object and on the orientation-free view is simultaneously performed;
- the creating the annotation comprises performing a first part of the user action in the orientation-free view and the second part of the user action in the at least one fixed view, each of the first and second parts of the user action being converted for the referential of the view on which the part of the user action is performed;
- the displaying at least one fixed view of the 3D modeled object comprises selecting a geometrical element on the orientation-free view of the 3D modeled and computing at least one orthographic view of the 3D modeled object from the selected geometrical element;
- the displaying at least one fixed view of the 3D modeled object further comprises selecting a section line on one of the at least one fixed view of the 3D modeled object, the section line defining a cutting plane; computing and displaying a section view of the at least one fixed view of the 3D modeled object across the cutting plane;
- filtering one or more elements of the orientation-free view of the 3D modeled object and/or of the at least one fixed view of the 3D modeled object, wherein the one or more elements are selected among: a part of the 3D modeled object representing the CAD assembly of parts; a geometrical element of the 3D modeled object representing the CAD mechanical part; a feature of the 3D modeled object representing the CAD mechanical part; the annotation type of an annotation previously created; making the filtered one or more elements selectable for creating the annotation;
- the at least one fixed view of the 3D modeled object comprises an axonometric fixed view of the 3D modeled object; and wherein the creating an annotation further comprises: displaying a graphical representation of a main support of the axonometric fixed view and a graphical representation of at least additional support; selecting one of the graphical representation; wherein the displaying the created annotation further comprises displaying the annotation in plane parallel to the select su pport;
- the creating the annotation further comprises determining whether the annotation to be displayed is partly or totally hidden in the at least one fixed view of the 3D modeled object; and displacing the annotation to be displayed until the annotation to be displayed is completely visible.
- the obtaining a 3D scene and displaying further comprises displays a toolbar embedded in the 3D scene, the tool bar being usable for each of the views of the 3D scene, the tool bar allows toggling between a first, second and third working modes, where the first working mode comprises displaying the orientation-free view of the 3D modeled object alone, the second working mode comprises displaying the at least one fixed view of the 3D modeled object alone, the third working mode comprises displaying both the orientation-free view of the 3D modeled object and the at least one fixed view of the 3D modeled object; - generating a 2D drawing compliant with a technical drawing from one or more of the at least one fixed view of the 3D modeled object.

It is further provided a computer program comprising instructions for performing the method.

It is further provided a computer readable storage medium having recorded thereon the computer program.

It is further provided a system comprising a processor coupled to a memory and a graphical user interface, the memory having recorded thereon the computer program.

### BRIEF DESCRIPTION OF THE DRAWINGS

Non-limiting examples will now be described in reference to the accompanying drawings, where:
- FIG. 1 shows a flowchart of an example of the method;
- FIG. 2 shows a comparison between known workflows and the workflows according to the invention;
- FIG. 3shows an example of a graphical user interface of the system;
- FIG. 4 shows an example of the system;
- FIGs. 5-6 and 26 show examples of the views and their organizations;
- FIGs. 7-12 show examples of creation of views;
- FIGs. 13-18 show examples of creations of annotations;
- FIGs. 18-20 show examples of creations of annotations with two geometrical elements selected;
- FIGs. 21-23 show examples of creations of annotation with a fixed axonometric view;
- FIG. 24 shows the generation of drawings compliant with technical drawings; and
- FIG. 25 shows an example of creation of an annotation.

### DETAILED DESCRIPTION

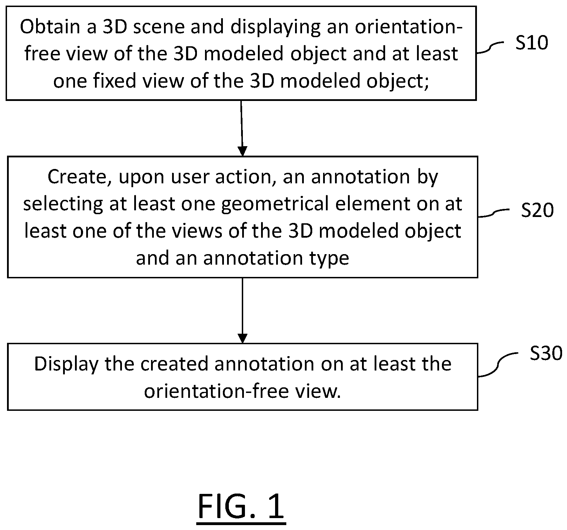

With reference to the flowchart of **FIG. 1****,** it is proposed a computer-implemented method for annotating a 3D modeled object representing a CAD mechanical part or assembly of parts. Two or more views of the 3D modeled object are displayed and at least one of the views is compliant with a view of a technical drawing. Hence, at least one of the views comprises the Product Manufacturing and Information (PMIs) required for the manufacturing of the 3D modeled object. Then, the method also comprises obtaining a 3D scene; the 3D scene is the 3D space in which the 3D modeled object is represented, as known in the art. Are displayed in the 3D scene an orientation-free view of the 3D modeled object and at least one fixed view of the 3D modeled object. The orientation-free view is a representation of the 3D modeled object that can be freely manipulated by the user, allowing them to modify the point of view on the representation as they wish and therefore see it from any angle. A fixed view is a representation of the 3D modeled object that cannot be manipulated by the user, no modification of the point of view is possible. Then, the user creates an annotation by selecting at least one geometrical element on at least one of the views of the 3D modeled object and an annotation type. Then, the created annotation is displayed on at least the orientation-free view. A single annotated 3D modeled object is thus displayed.

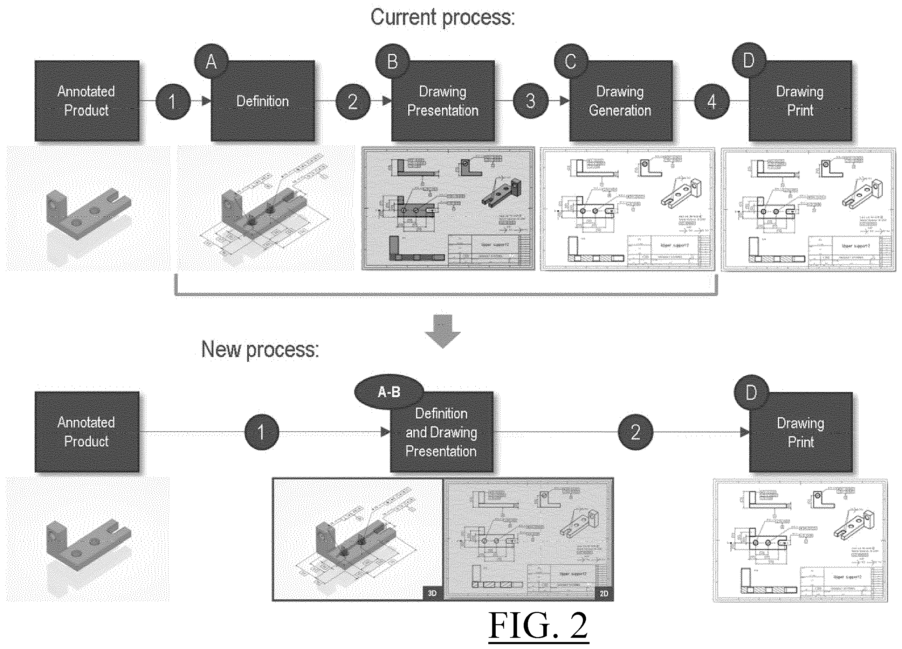

Such a method improves the annotation of a 3D modeled object representing a CAD mechanical part or assembly of parts. Notably, the dual presentation of the orientation-free view together with the fixed view(s) of the 3D modeled object-where at least one of the fixed view is compliant with a view of a technical drawing-improves ergonomics for the creation of annotations, while obtaining one annotated single 3D modeled object. Ergonomics are improved as the designer can create an annotation starting from the orientation-free view or from one of the fixed view(s) of the 3D modeled object, and the user does not need to have concerns regarding the synchronization between the two types of views and the transfer of modifications. Furthermore, as one single 3D modeled object is annotated, the definition is the 3D one, considered as the master, whatever the environment used (3D or 2D oriented). As shown on **FIG. 2****,** this involves that the user does not need any more to switch back and forth between a second application B used for adding annotations that are not present on the 3D modeled object and a first application A in which the 3D modeled is defined, which is cumbersome task for the user; the same between the application B and a third application C that generates the technical drawings. The one single 3D modeled object is considered as the master, whatever the environment used (orientation-free view or fixed view), and it is possible to edit/amend the one single 3D modeled object from a fixed view, while keeping in the same 3D scene without switching to a different application, as represented on the bottom of FIG. 2. The orientation-free and fixed views of the 3D modeled object are merged in the same 3D scene without interactive transition, e.g. for the authoring of the definition in 3D space and preparing final drawing presentation in 2D space.

Further advantages of the invention will be discussed in this description.

The method is computer-implemented. This means that steps (or substantially all the steps) of the method are executed by at least one computer, or any system alike. Thus, steps of the method are performed by the computer, possibly fully automatically, or, semi-automatically. In examples, the triggering of at least some of the steps of the method may be performed through user-computer interaction. The level of user-computer interaction required may depend on the level of automatism foreseen and put in balance with the need to implement user's wishes. In examples, this level may be user-defined and/or pre-defined.

For instance, the step of creating is performed upon user action in the 3D scene, where the user selects an annotation type and at least geometrical element on at least one 3D view of the 3D modeled object.

A typical example of computer-implementation of a method is to perform the method with a system adapted for this purpose. The system may comprise a processor coupled to a memory and a graphical user interface (GUI), the memory having recorded thereon a computer program comprising instructions for performing the method. The memory may also store a database. The memory is any hardware adapted for such storage, possibly comprising several physical distinct parts (e.g. one for the program, and possibly one for the database).

The method generally manipulates 3D modeled objects (also referred to as modeled objects in the description). A 3D modeled object is any object defined by data stored e.g. in the database. By extension, the expression "3D modeled object" designates the data itself. According to the type of the system, the 3D modeled objects may be defined by different kinds of data. The system may indeed be any combination of a CAD system, a CAE system, a CAM system, a PDM system and/or a PLM system. In those different systems, 3D modeled objects are defined by corresponding data. One may accordingly speak of CAD object, PLM object, PDM object, CAE object, CAM object, CAD data, PLM data, PDM data, CAM data, CAE data. However, these systems are not exclusive one of the other, as a 3D modeled object may be defined by data corresponding to any combination of these systems. A system may thus well be both a CAD and PLM system, as will be apparent from the definitions of such systems provided below.

By CAD system, it is additionally meant any system adapted at least for designing a modeled object on the basis of a graphical representation of the modeled object, such as CATIA. In this case, the data defining a modeled object comprise data allowing the representation of the modeled object. A CAD system may for example provide a representation of CAD modeled objects using edges or lines, in certain cases with faces or surfaces. Lines, edges, or surfaces may be represented in various manners, e.g. non-uniform rational B-splines (NURBS). Specifically, a CAD file contains specifications, from which geometry may be generated, which in turn allows for a representation to be generated. Specifications of a modeled object may be stored in a single CAD file or multiple ones. The typical size of a file representing a modeled object in a CAD system is in the range of one Megabyte per part. And a modeled object may typically be an assembly of thousands of parts.

In the context of CAD, a modeled object may typically be a 3D modeled object, e.g. representing a product such as a part or an assembly of parts, or possibly an assembly of products. By "3D modeled object", it is meant any object which is modeled by data allowing its 3D representation. A 3D representation allows the viewing of the part from all angles. For example, a 3D modeled object, when 3D represented, may be handled and turned around any of its axes, or around any axis in the screen on which the representation is displayed. This notably excludes 2D icons, which are not 3D modeled. The display of a 3D representation facilitates design (i.e. increases the speed at which designers statistically accomplish their task). This speeds up the manufacturing process in the industry, as the design of the products is part of the manufacturing process.

The 3D modeled object represents the geometry of a product to be manufactured in the real world subsequent to the completion of its virtual design with for instance a CAD software solution or CAD system, such as a (e.g. mechanical) part or assembly of parts (or equivalently an assembly of parts, as the assembly of parts may be seen as a part itself from the point of view of the method, or the method may be applied independently to each part of the assembly), or more generally any rigid body assembly (e.g. a mobile mechanism). A CAD software solution allows the design of products in various and unlimited industrial fields, including: aerospace, architecture, construction, consumer goods, high-tech devices, industrial equipment, transportation, marine, and/or offshore oil/gas production or transportation. The 3D modeled object designed by the method may thus represent an industrial product which may be any mechanical part, such as a part of a terrestrial vehicle (including e.g. car and light truck equipment, racing cars, motorcycles, truck and motor equipment, trucks and buses, trains), a part of an aerial vehicle (including e.g. airframe equipment, aerospace equipment, propulsion equipment, defense products, airline equipment, space equipment), a part of a naval vehicle (including e.g. navy equipment, commercial ships, offshore equipment, yachts and workboats, marine equipment), a general mechanical part (including e.g. industrial manufacturing machinery, heavy mobile machinery or equipment, installed equipment, industrial equipment product, fabricated metal product, tire manufacturing product), an electro-mechanical or electronic part (including e.g. consumer electronics, security and/or control and/or instrumentation products, computing and communication equipment, semiconductors, medical devices and equipment), a consumer good (including e.g. furniture, home and garden products, leisure goods, fashion products, hard goods retailers' products, soft goods retailers' products), a packaging (including e.g. food and beverage and tobacco, beauty and personal care, household product packaging).

A CAD system may be history-based. In this case, a modeled object is further defined by data comprising a history of geometrical features. A modeled object may indeed be designed by a physical person (i.e. the designer/user) using standard modeling features (e.g. extrude, revolute, cut, and/or round) and/or standard surfacing features (e.g. sweep, blend, loft, fill, deform, and/or smoothing). Many CAD systems supporting such modeling functions are history-based system. This means that the creation history of design features is typically saved through an acyclic data flow linking the said geometrical features together through input and output links. The history-based modeling paradigm is well known since the beginning of the 80's. A modeled object is described by two persistent data representations: history and B-rep (i.e. boundary representation). The B-rep is the result of the computations defined in the history. The shape of the part displayed on the screen of the computer when the modeled object is represented is (e.g. a tessellation of) the B-rep. The history of the part is the design intent. Basically, the history gathers the information on the operations which the modeled object has undergone. The B-rep may be saved together with the history, to make it easier to display complex parts. The history may be saved together with the B-rep in order to allow design changes of the part according to the design intent.

By PLM system, it is additionally meant any system adapted for the management of a modeled object representing a physical manufactured product (or product to be manufactured). In a PLM system, a modeled object is thus defined by data suitable for the manufacturing of a physical object. These may typically be dimension values and/or tolerance values. For a correct manufacturing of an object, it is indeed better to have such values.

By CAM solution, it is additionally meant any solution, software of hardware, adapted for managing the manufacturing data of a product. The manufacturing data generally includes data related to the product to manufacture, the manufacturing process and the required resources. A CAM solution is used to plan and optimize the whole manufacturing process of a product. For instance, it can provide the CAM users with information on the feasibility, the duration of a manufacturing process or the number of resources, such as specific robots, that may be used at a specific step of the manufacturing process; and thus allowing decision on management or required investment. CAM is a subsequent process after a CAD process and potential CAE process. Such CAM solutions are provided by Dassault Systèmes under the trademark DELMIA^{®}.

By CAE solution, it is additionally meant any solution, software of hardware, adapted for the analysis of the physical behavior of a modeled object. A well-known and widely used CAE technique is the Finite Element Method (FEM) which typically involves a division of a modeled objet into elements which physical behaviors can be computed and simulated through equations. Such CAE solutions are provided by Dassault Systèmes under the trademark SIMULIA^{®}. Another growing CAE technique involves the modeling and analysis of complex systems composed a plurality components from different fields of physics without CAD geometry data. CAE solutions allow the simulation and thus the optimization, the improvement and the validation of products to manufacture. Such CAE solutions are provided by Dassault Systèmes under the trademark DYMOLA^{®}.

PDM stands for Product Data Management. By PDM solution, it is meant any solution, software of hardware, adapted for managing all types of data related to a particular product. A PDM solution may be used by all actors involved in the lifecycle of a product: primarily engineers but also including project managers, finance people, sales people and buyers. A PDM solution is generally based on a product-oriented database. It allows the actors to share consistent data on their products and therefore prevents actors from using divergent data. Such PDM solutions are provided by Dassault Systèmes under the trademark ENOVIA^{®}.

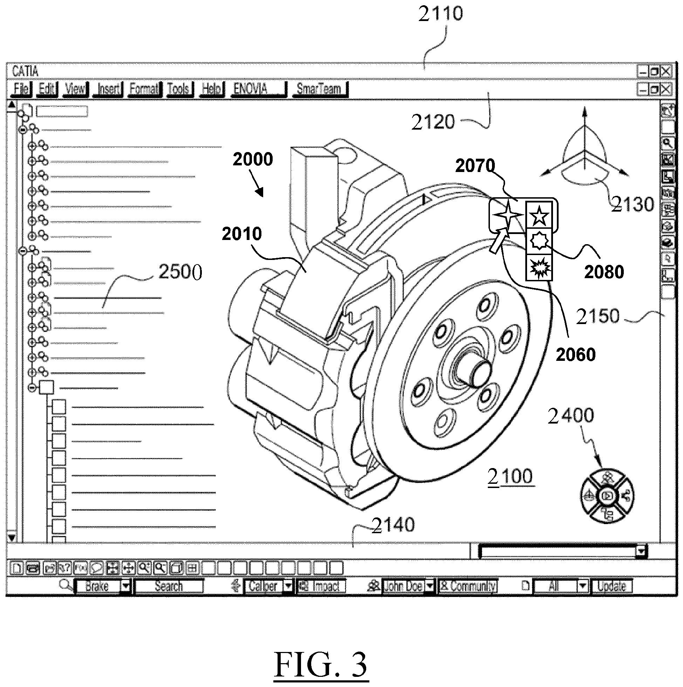

**FIG. 3** shows an example of the GUI of the system, wherein the system is a CAD system.

The GUI 2100 may be a typical CAD-like interface, having standard menu bars 2110, 2120, as well as bottom and side toolbars 2140, 2150. Such menu- and toolbars contain a set of user-selectable icons, each icon being associated with one or more operations or functions, as known in the art. Some of these icons are associated with software tools, adapted for editing and/or working on the 3D modeled object 2000 displayed in the GUI 2100. The software tools may be grouped into workbenches. Each workbench comprises a subset of software tools. In particular, one of the workbenches is an edition workbench, suitable for editing geometrical features of the modeled product 2000. In operation, a designer may for example pre-select a part of the object 2000 and then initiate an operation (e.g. change the dimension, color, etc.) or edit geometrical constraints by selecting an appropriate icon. For example, typical CAD operations are the modeling of the punching or the folding of the 3D modeled object displayed on the screen. The GUI may for example display data 2500 related to the displayed product 2000. In the example of the figure, the data 2500, displayed as a "feature tree", and their 3D representation 2000 pertain to a brake assembly including brake caliper and disc. The GUI may further show various types of graphic tools 2130, 2070, 2080 for example for facilitating 3D orientation of the object, for triggering a simulation of an operation of an edited product or render various attributes of the displayed product 2000, for selecting a type of annotation. A cursor 2060 may be controlled by a haptic device to allow the user to interact with the graphic tools.

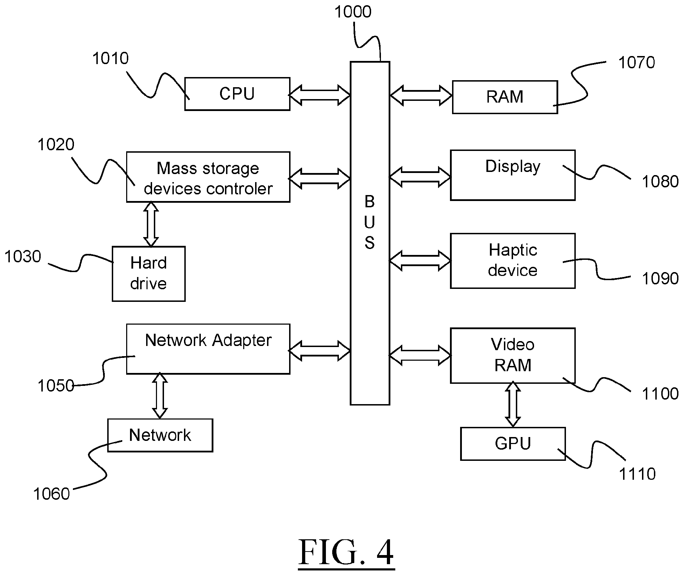

**FIG. 4** shows an example of the system, wherein the system is a client computer system, e.g. a workstation of a user.

The client computer of the example comprises a central processing unit (CPU) 1010 connected to an internal communication BUS 1000, a random-access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 1050 manages accesses to a network 1060. The client computer may also include a haptic device 1090 such as cursor control device, a keyboard or the like. A cursor control device is used in the client computer to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

The computer program may comprise instructions executable by a computer, the instructions comprising means for causing the above system to perform the method. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method. The computer program may alternatively be stored and executed on a server of a cloud computing environment, the server being in communication across a network with one or more clients. In such a case a processing unit executes the instructions comprised by the program, thereby causing the method to be performed on the cloud computing environment.

"Annotating a 3D modeled object" designates any action or series of actions which is at least part of a process of adding annotations on a 3D modeled object. Thus, the method may comprise adding the annotation on the 3D modeled object from scratch. Alternatively, the method may comprise providing a 3D modeled object previously created that already comprises annotations, and then modifying the annotations that are already present and/or adding further annotations on the 3D modeled object.

The method can be included in a manufacturing process, which may comprise, after performing the method, producing a physical product corresponding to the annotated 3D modeled object. As already discussed, the purpose of the annotations is to provide the necessary information allowing the production of the 3D modeled object. In any case, the 3D modeled object designed by the method represents a manufacturing object. The modeled object may thus be a modeled solid (i.e. a modeled object that represents a solid). The manufacturing object may be a product, such as a (CAD) mechanical part, or an assembly of parts. Because the method improves the annotating of 3D the modeled object, the method also improves the manufacturing of a product and thus increases productivity of the manufacturing process.

Referring back to FIG. 1, at S10, a 3D scene is obtained. "3D scene" refers to the 3D digital space where three-dimensional models are created, modified, and visualized. Obtaining a 3D scene means that the system that carries out the present method can access data related to the 3D scene so that the next steps of the method can be performed.

Still in reference to **S10,** an orientation-free view of the 3D modeled object is displayed. The orientation-free view is a representation of the 3D modeled object that can be freely manipulated by the user, allowing them to modify the point of view on the representation as they wish and therefore see it from any angle. An orientation-free view thus refers to a visualization or representation of a 3D object that is not fixed to a specific orientation or perspective. In other words, it allows the viewer to interactively rotate, pan, and zoom around the object or scene to examine it from any angle without being constrained to predefined viewpoints.

Still in reference to **S10,** at least one fixed view of the 3D modeled object is displayed. A fixed view is a representation of the 3D modeled object that cannot be manipulated by the user: no modification of the point of view is possible. Thus, a fixed view refers to a viewpoint on the 3D modeled object that remains constant and does not change dynamically as the user interacts with the 3D scene. Unlike orientation-free views, which allow for interactive rotation, panning, and zooming, a fixed view is locked to a specific angle and position. For example, orthographic views are fixed views of the 3D modeled object: top, front, side views are 2D representations in the 3D scene of the object from different angles.

The displaying of the orientation-free view of the 3D modeled object and of the at least one fixed view of the 3D modeled object can be done in any order, or even simultaneously.

At least one of the views is compliant with a view of a technical drawing. A technical drawing, also referred to as an engineering drawing, is a detailed and precise illustration of the 3D modeled object, intended to communicate the dimensions, geometry, and other specifications necessary for its manufacture. Technical drawings provides clear and standardized way to convey complex information, e.g. for the manufacturing of the 3D modeled object.

Examples of the displaying **S10** are now discussed. The orientation-free view of the 3D modeled object and the at least one fixed view of the 3D modeled object are in the 3D scene.

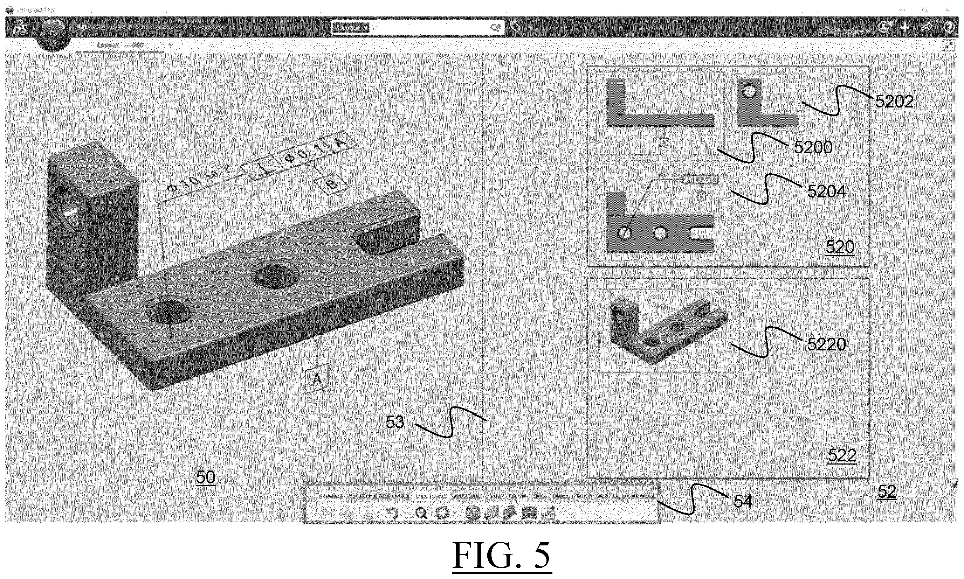

**FIG. 5** is a screenshot of a so-called mixed working mode where both views are displayed. The 3D scene is divided into two spaces: the left side **50** with the orientation-free view of the 3D modeled object and the right side **52** with the at least one fixed view of the 3D modeled object. Both left and right sides belong to the 3D scene, but a line **53** may be displayed in order to show a graphical representation of the boundary between the two sides. On **FIG. 5****,** the line **53** is shown in the middle of the 3D scene that is shown on the Graphical User Interface (GUI) as both left and right sides have the same dimension; being understood that the left and right sides may have different dimensions. In examples, the line can be displaced upon user action, e.g. the user can grab with a haptic device the line and displace it to the right or to the left. The user can therefore modify the dimension of the left and right sides, e.g. the sides are adapted to their needs.

**In** **FIG. 5****,** the orientation-free view of the 3D modeled object is on the left and the at least one fixed view of the 3D modeled object on the right. It is to be understood that any other organization may be contemplated, e.g. the orientation-free view of the 3D modeled object is on the right and the at least one fixed view of the 3D modeled object on the left, or the orientation-free view of the 3D modeled object is on the top and the at least one fixed view of the 3D modeled object on the bottom, or the orientation-free view of the 3D modeled object is on bottom and the at least one fixed view of the 3D modeled object on the top. The same features discussed for the organization of **FIG. 5** can apply to the alternate organizations.

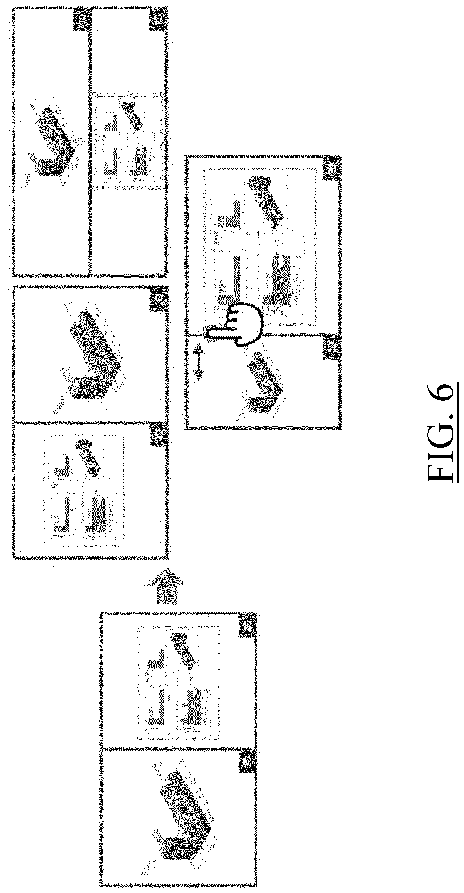

**FIG. 6** shows examples of other organizations, and also shows an example of modifications of dimensions of the left and right sides. It is to be understood that the modifications of dimensions may be applied to the case the orientation-free view of the 3D modeled object is on the top and the at least one fixed view of the 3D modeled object on the bottom, and inversely. FIG. 6 further illustrates that the line materializing the boundary between the fixed views(s) side and the orientation-free view side may be displaced upon user action.

Still in **FIG. 5**, the left side **50** comprises orientation-free view of the 3D modeled object in the 3D scene with two annotations. The right side **52** may show one or more layouts. A layout relates to the arrangement and organization of various view for preparing final presentations of the views. On **FIG. 5****,** the right side comprises one layout. In examples, a layout may comprise one or more sheets. A sheet of a layout refer to an individual drawing sheet where a final presentation of 3D modeled object - for example a view that is compliant with a technical drawing - is organized and prepared for printing or digital sharing. On **FIG. 5****,** the layout of the right side comprises two sheets **520** and **522.** The sheets may be materialized by a quadrilateral. In **FIG. 5****,** the sheets 520 and 522 are represented by rectangles. The sheet 520 shows three orthographic views 5500, 5502, 5504 of the 3D modeled object. The sheet 522 shows an isometric fixed view 5220 of the 3D modeled object. It is to be understood that the sheets can be placed in any position on the layout, e.g. one above the other, or side by side. The sheets may not be superposed in order to ensure visibility of the view they represent. As shown on **FIG. 5****,** each fixed view of the 3D modeled object may be surrounded by a quadrilateral. In examples, the color of each quadrilateral may be used for conveying the information of which of the fixed view of the 3D modeled object is the default view. For example, in **FIG. 5****,** the default view 5200 is highlighted, e.g. surrounded by a rectangle with a color different to the color of the rectangle surrounding the other views 5202, 5504 and 5220. The default view will be discussed later. It is also to be understood that the fixed views may be placed on any sheet and/or displaced from a first sheet to a second sheet, e.g. by performing a drag and drop action and/or displaced from a first layout to a second layout.

Still on **FIG. 5****,** is shown a toolbar **54** that is embedded in the 3D scene. The toolbar is thus an object of the 3D scene and can be used with both the orientation-free and the fixed views. This avoids having a toolbar for each view. The toolbar comprises icons that can be activated upon user action, e.g. using a haptic device; each icon, when activated, triggers a function. The toolbar will be discussed later.

In examples, a specification tree of the 3D modeled object - among 3D and 2D global viewpoints- may be embedded in the 3D scene. As for the toolbar, this avoids having a specification tree for each of the orientation-free and fixed views. The specification tree allows, but is not limited to, calling and/or saving views, selecting an orientation of the orientation-free view...

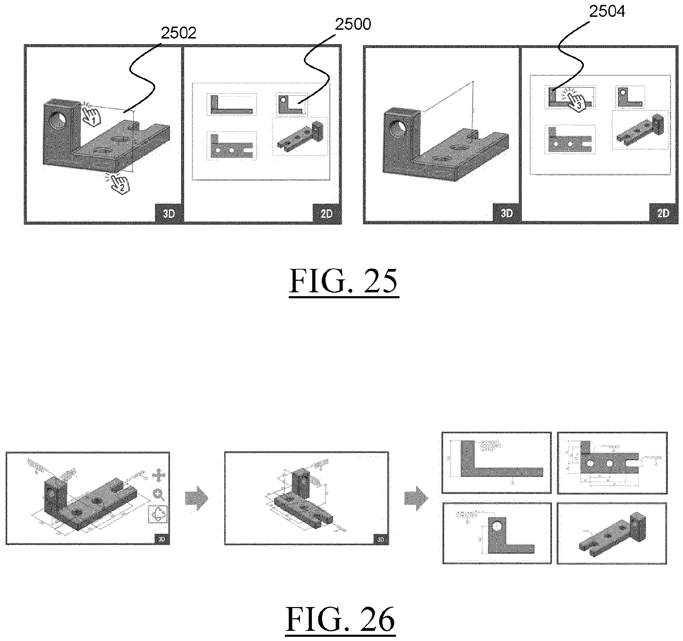

The so-called mixed working mode has been discussed in reference to **FIG. 5****.** A further working mode, called full 3D working mode, allows to display on demand various viewpoints successively, as illustrated on FIG. 26. From the left to the right of FIG. 26, a first orientation-free view has been displayed to the user. Then a second orientation-free view is shown to the user, e.g. the user has rotated the 3D modeled object. Finally, fixed views of the 3D modeled object are shown.

A third working mode, which is called full 2D working mode may be made available to the user. Only the fixed views of the 3D modeled object are shown to the user.

The toolbar may comprise dedicated icons for toggling between the first, second and third working modes. As already said, the first working mode comprises displaying the orientation-free view of the 3D modeled object alone, the third working mode comprises displaying the at least one fixed view of the 3D modeled object alone, and the second working mode comprises displaying both the orientation-free view of the 3D modeled object and the at least one fixed view of the 3D modeled object. All these three working modes are serving the invention purpose by allowing making a 3D definition which will be readable, understandable, editable, manipulable, in both 3D and/or 2D environment with final drawing presentation.

Examples of the creation of the fixed views are now discussed. The creation is performed at **S10** but may be also performed at any subsequent step of the method according to the invention, e.g. in the course of the creations of annotations. This is made possible as the fixed view are obtained (created) from the single 3D modeled object that is to be (or has already been) annotated. The creation of a fixed view may comprise the selection of a geometrical element on the orientation-free view of the 3D modeled. Here geometrical element comprises vertices, edges, faces of the 3D modeled object, but it may also comprise the features of the 3D modeled object that comprise basic geometric features such as extrude, revolve, sweep, loft, advanced geometric features such as fillet, round, chamfer, functional features such as hole, boss, pocket...

In an example, the selection of the geometrical element may be performed automatically by the system. For example, the system determines the main faces of the 3D modeled object and select one of the main faces. A main face may be a face with one of the largest surfaces among the other faces of the 3D modeled object.

In an example, the selection of the geometrical element may be performed upon user action; the user selects a geometrical element by use of a haptic device.

Once the selection of the geometrical element has been performed, an orthographic view of the 3D modeled object is computed from the selected geometrical element. An orthographic view is a view representing the 3D modeled object in 2D, without any perspective distortion. The selected geometrical element that is used for computing the orthographic view determines, on the 3D modeled object, various points of interest ; those points of interest are mapped by the orthographic projection to points on a projection plane that is perpendicular to a projection line, thereby creating a 2D representation that is one of the at least one fixed view of the 3D modeled object. The orthographic projection thus involves projecting at least the selected geometrical element onto a plane using parallel lines that are perpendicular to the projection plane. The selection of the geometrical element may define the front fixed view of the 3D modeled object.

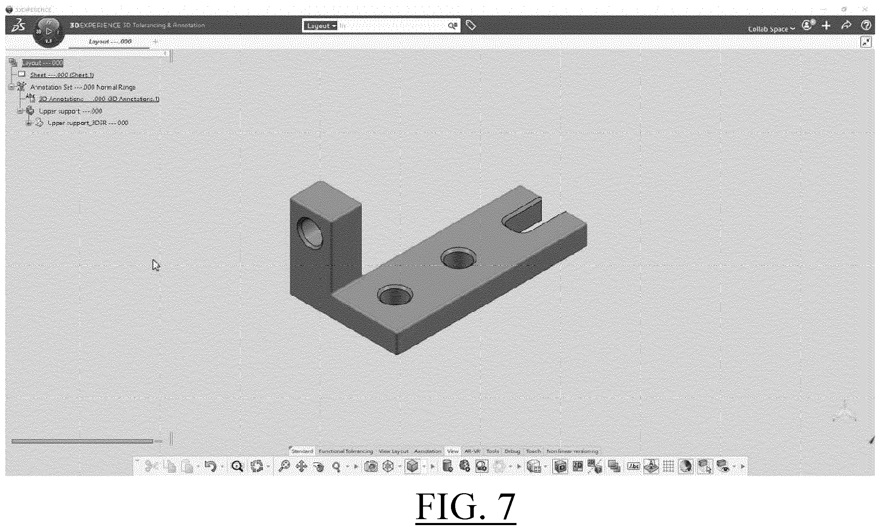

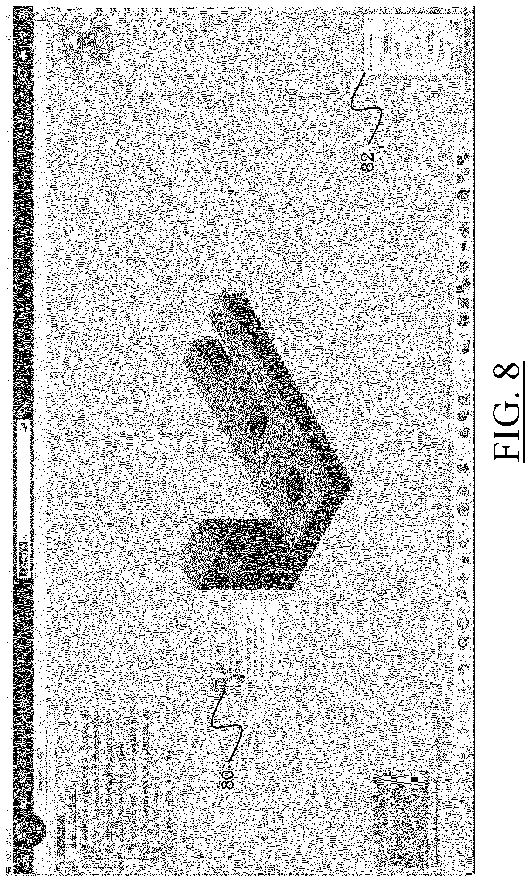

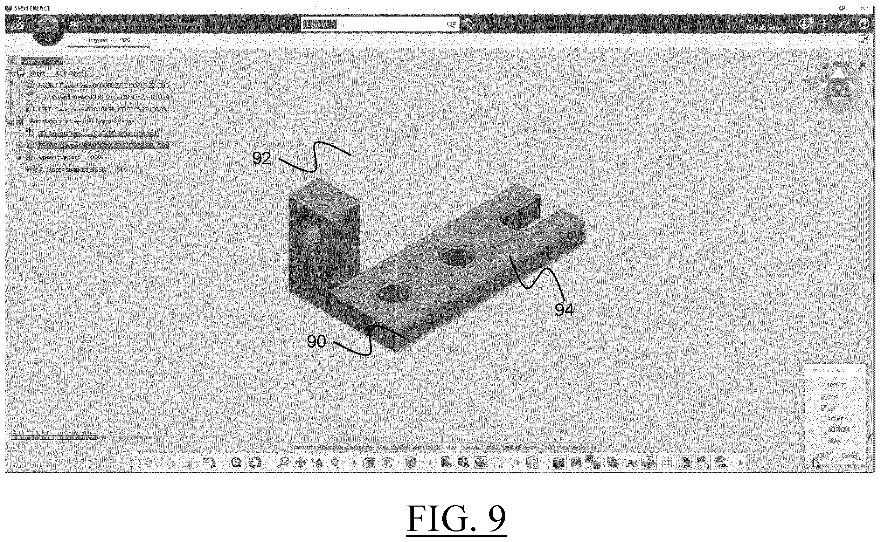

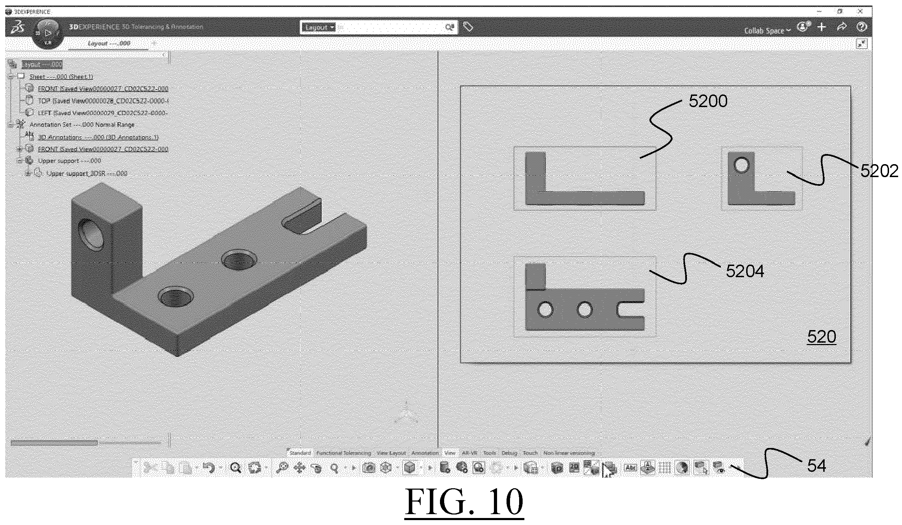

**FIGs. 7 to 10** are screenshots that illustrate an example of the creation of the fixed views. **On** **FIG. 7** is shown the orientation-free view of the 3D modeled object, e.g. the first working mode is activated. On **FIG. 8****,** the user has triggered the displaying of an interactive menu 80 that appeared under the location of a user interaction on the computer display, e.g. under the cursor manipulated by the user with a haptic device, or under the location where the user interacted with an appendage on a computer touch-sensitive screen. The user selects the creation of at least one fixed view, e.g. a front view on the 3D modeled object. The displaying of an interactive menu **80** may also comprise the display of sub-menu 82 that allows selecting/deselecting further main views, such as top, left, right, bottom or rear fixed views. In this example, the selection of the creation of at least one fixed view on the interactive menu **80** triggers the creation of the main, top and left fixed views by default; the interactive boxes of the top and left fixed views are checked on the sub-menu **82.** Thus, if the user only wants the creation of the front fixed view, they can uncheck the relevant boxes in the sub-menu **82.** It is to be understood that the number of fixed views proposed by default may be configured at any time. Then, the user selects a geometrical element of the 3D modeled object, as shown on **FIG. 9** where the user has selected the face **90.** The selected geometrical element may be highlighted so that the user is confirmed their selection has been taken into account by the system. The selection of the geometrical element of the 3D modeled object may further comprise the display of a bounding box 92 that shows the potential planes on which the orthographic projections can be carried out. In this example, the selected face 90 defines the front fixed view of the 3D modeled object, that is, this geometrical element will be totally represented on the computed fixed view. The selection of the geometrical element of the 3D modeled object may further comprise the displaying of a referential that shows the positioning of the bounding box about the 3D modeled object; the referential shows the x, y and z coordinates, and the z coordinate may be highlighted. The z coordinate is the one according to which the 3D modeled object is orthographically projected. As a result of the former steps, the at least one fixed view of the 3D modeled object has been computed. The data representing the fixed views can be accessed by the system, e.g. they are stored on a memory that may belong to the system. The fixed views can therefore be displayed, as shown on **FIG. 10****.** In an example, the display is automatically performed by the system as soon as they have been computed. In another example, the user can trigger the display of the fixed view, e.g. by interaction with the toolbar **54.** Still in reference to **FIG. 10****,** the front view **5200** of the 3D modeled object among the fixed views of the sheet **520** is highlighted in order to indicate to the user the default view is the front view **5200.**

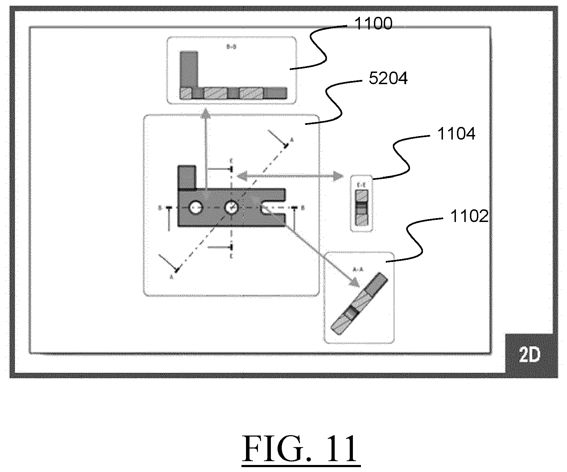

In examples, the displaying at least one fixed view of the 3D modeled object may further comprise computing and displaying a section view of the 3D modeled object. A section view is a type of fixed view that reveals the internal features of the 3D modeled object that are not visible in the standard orientation-free or fixed views, as known in the art. In an example, a section line is selected on one of the at least one fixed view of the 3D modeled object, e.g. the user draws a line over the fixed view. The section line defines a cutting plane. Next, the section view of the at least one fixed view of the 3D modeled object across the cutting plane is computed and displayed. **FIG. 11** shows section views computed on the top fixed view 5204 of the 3D modeled object of **FIG.10****.** Three section lines have been defined by the user on the fixed view, and each of these section line has caused the generation of a sectional fixed view 1100, 1102 and 1104. The arrows show what section line has generated what sectional fixed view. It is to be understood that a sectional fixed view may be generated from the orientation-free view, where the user defines a cutting plane thought the 3D modeled object and a sectional fixed view can be displayed.

In examples, the displaying at least one fixed view of the 3D modeled object may further comprise computing and displaying a trimetric view of the 3D modeled object. The user can trigger the display of the trimetric view, e.g. by interaction with the toolbar **54** that provides an access to a function that computes automatically the trimetric view.

Once the step **S10** has been carried out, an annotation can be created **S20**. The creation of an annotation is performed upon user action. To that aim, the user selects an annotation type. An annotation conveys additional technical information that is not directly represented by the geometry of the design. An annotation type is a category of technical information. The annotation type may be selected among, but is not limited to, dimension annotations, text annotations, geometric dimensioning and tolerancing, surface finish annotations, weld annotations, hole and thread annotations, datum and reference annotations... The type of annotations may be defined by standards, e.g. the ones proposed by ISO - International Organization for Standardization, ASME - American Society of Mechanical Engineers and JIS - Japanese Industrial Standard. The selection of an annotation type may be performed with the toolbar that can propose a list of annotation type. The type of annotation been selected, at least one geometrical element is selected by the user. The selection of the geometrical element may comprise the selection of a geometrical element on the orientation-free view of the 3D modeled or a selection of geometrical element on the fixed view of the 3D modeled. As already discussed in reference to **S10,** geometrical element comprises vertices, edges, faces of the 3D modeled object, but it may also comprise the features of the 3D modeled object that comprise basic geometric features such as extrude, revolve, sweep, loft, advanced geometric features such as fillet, round, chamfer, functional features such as hole, boss, pocket... The selection of the geometrical element is performed as known in the art, e.g. upon user action by use of a haptic device or by use of an appendage (e.g. a finger, a stylet...) on a touch sensitive screen. As a result of both actions is created an annotation of the selected geometrical element.

It is to be understood that the selection of the annotation type may be performed before or after the selection of the geometrical element without modifying the creation of the annotation.

In examples, the creating the annotation may further comprise transferring the created annotation on at least one of the other views of the 3D modeled object. It is to be understood that the transfer of the created annotation does not necessarily involve a display but ensures that the annotation can be displayed on the at least one of the other views of the 3D modeled object with an orientation corresponding to the orientation of the other view on which the annotation is transferred.. An example of the transfer is discussed hereinafter in reference to FIG. 25. In examples, the transfer may be performed by modifying parameters of the annotations so that the annotation is associated to the new view (e.g. the new when has been selected by the user). In examples, the transfer of an annotation may further comprise making available or copying the data relative to the annotation that has been created on at least one of the views of the 3D modeled object on one or more other views of the 3D modeled.

The created annotation is then displayed **S30** on at least the orientation-free view. The one single 3D modeled object is therefore annotated, and the annotation is shown to the user.

In examples, the displaying further comprises displaying the annotation on the at least one of the other views of the 3D modeled object. This implies that the created annotation has been transferred on the said at least one of the other views of the 3D modeled object. In these example, the at least one of the other views of the 3D modeled object is a fixed view of the 3D modeled object.

Still in these example, the displaying of the annotation on the said at least one of the other views of the 3D modeled object and on the orientation-free view is simultaneously performed. This improves the comprehension for the user of the annotations. In an example, the annotations are displayed on each view of the 3D modeled object.

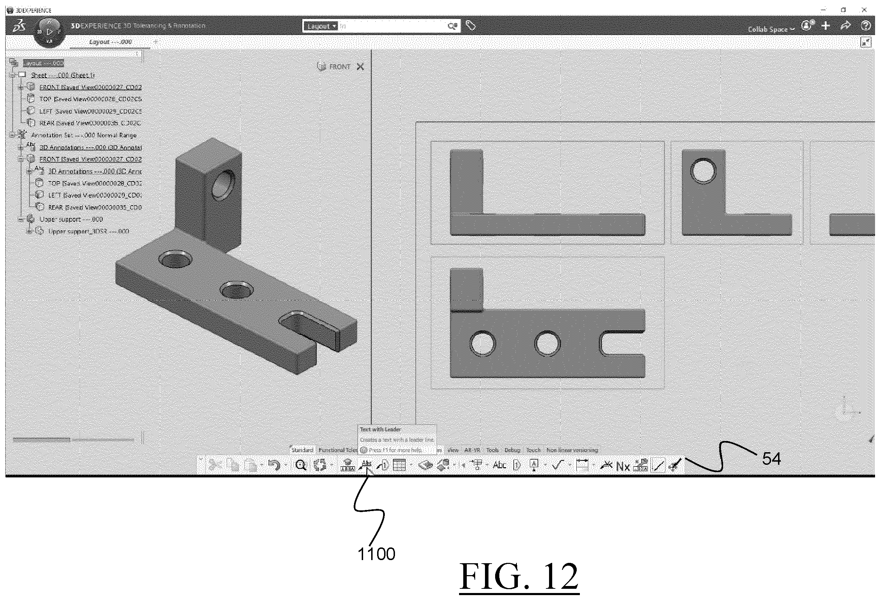

Referring now to **FIG. 12****,** an example of the creation of an annotation is discussed. The user wants to add an annotation of the type "text". They select the annotation type via the toolbar **54** by actuating the icon **1100** dedicated for creating this type of annotation. The selection of the annotation type having been done, the user selects a geometrical element of the 3D modeled object

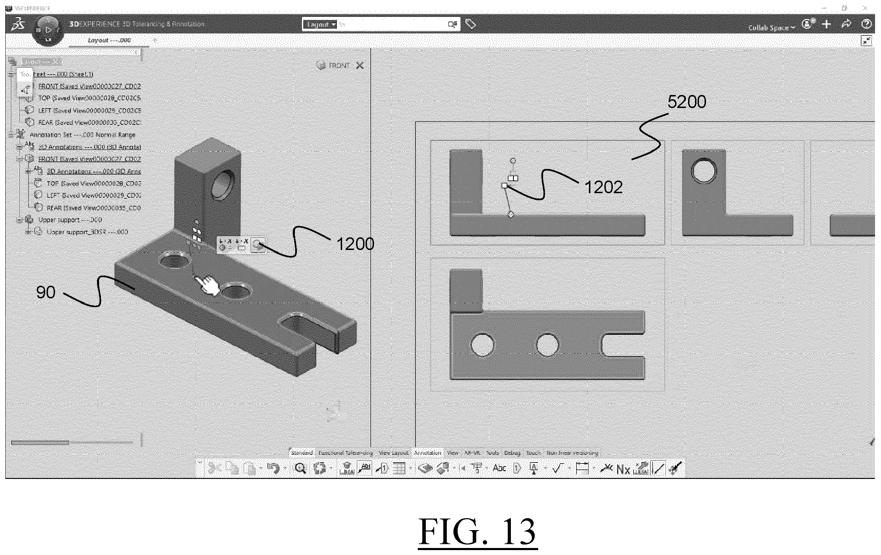

In **FIG. 13**, the geometrical element has been selected on the orientation-free view. The selected geometrical element is a face of the 3D modeled object. The selected geometrical element is highlighted on all the views, and as result of the selection, an annotation **1200, 1202** is displayed on the orientation-free view and on the fixed view **5200** of the front.

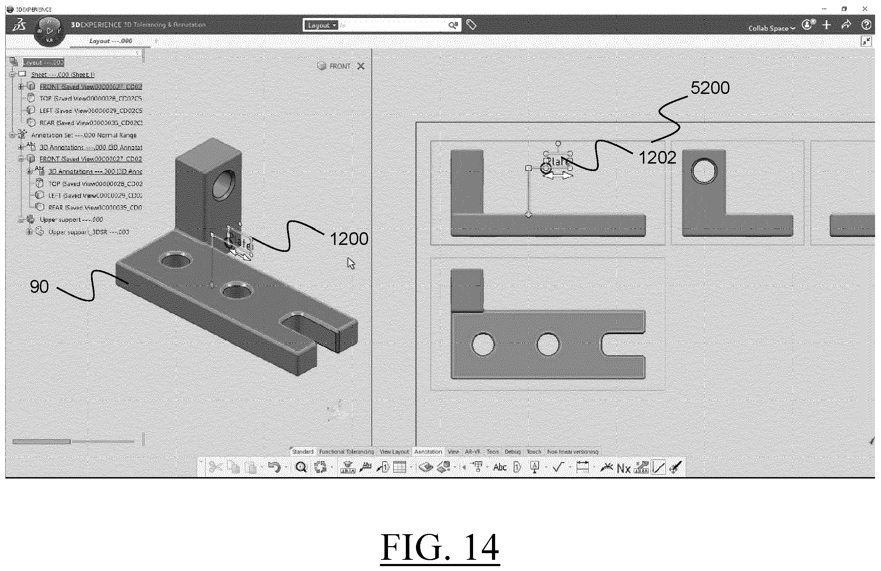

In reference now to **FIG. 14****,** the user may continue the creation of the annotation by entering text, for example "plate", displacing the annotation until the position is satisfying and/or modifying the shape of the annotation, e.g. the annotation may comprise manipulators for manipulating the annotation. While the annotation is manipulated, the annotation may be highlighted so that the user can make the distinction between the annotation being created and other annotations that may be already shown on the views.

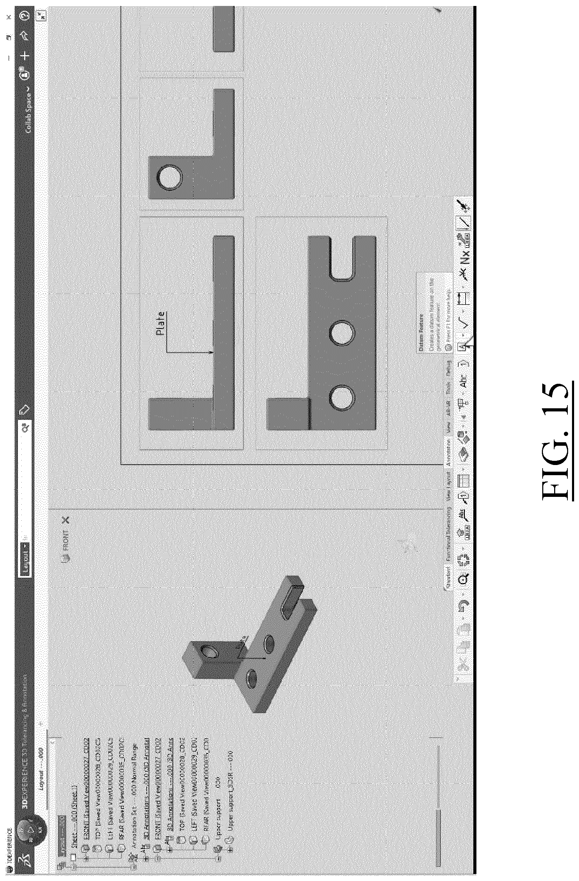

**FIG. 15** shows the annotation after its creation has been done.

General explanations of the creation of an annotation are now discussed in reference to **FIGs. 10** to **15****.** These general explanations are not bounded to these examples that merely serve for the sake of explanations. In these examples, the fixed view **5200** is the view obtained for the selected geometrical element **90** at the step of obtaining the fixed views, as discussed for example in reference to **FIG. 5**. The default view is thus the front fixed obtained by an orthographic projection of the 3D modeled object about the z coordinate. The term default means that the 2D representation of front fixed view forms a plane on which an annotation is expected to be read. For example, as shown on **FIG. 14**, the annotation 1202 of the type "text" (with the text "plate") is orthogonal to the z coordinate, that is, in a plane parallel to the view of the front fixed view. Consequently, and as there is only one single 3D modeled object, the annotation **1200** is shown in the rotation-free view with the same orientation as in the fixed view **5200.** It is to be understood that the default fixed can be changed at any time and that each annotation can be created with another default view. The change of a default is performed upon user action, e.g. by acting on the rectangle that surrounds the view to be set as default view. Hence, if the creation of an annotation starts on the default fixed view, then the annotation will have the same orientation as the orientation of the default fixed view. If the creation of an annotation starts on the fixed view that is not the default view, the annotation will have the same orientation as the orientation of the fixed view. If the creation of an annotation starts on the orientation-free view, the annotation will have the orientation of the default fixed view.

In examples, the creation of one annotation may be performed with user interactions performed on both the orientation-free view and the fixed view. For example, the user start the creation of the annotation on a first view and perform a subsequent action (e.g. a manipulation) on the annotation in another view. As another example, a first part of the user action may be performed in the orientation-free view and the second part of the user action in the at least one fixed view; the annotation manipulation at creation (following the mouse) can start on one side and end on the other side when moving mouse over global viewpoints. The first part of the user action and the second part of the user action are converted, on the fly, for the referential of the view on which the part of the user action is performed.

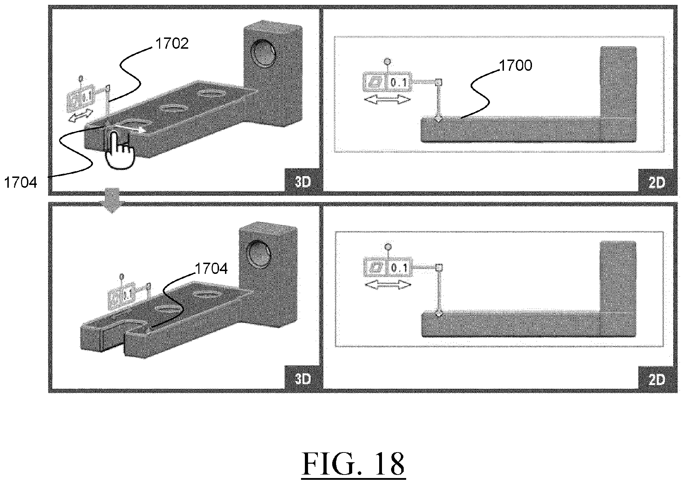

Referring now to **FIG. 18****,** is represented an example of the creation of an annotation that is performed both on the orientation-free view (3D) and the fixed view (2D). In this example, the user has started the creation of the annotation by selecting the geometrical element **1700** on the fixed view (2D) and an annotation type; the annotation has been created and displayed on the two views. The annotation has the same orientation in the 3D space on both views - the orientation is the one of the view of the fixed view. The connection **1702** of the annotation with the free-orientation view has been automatically created, but it can be displaced upon user action on the manipulator **1704,** e.g. the user selects the manipulator and displaces it to the desired location on the selected geometrical element. While the manipulator is displaced, it may be kept in contact with the geometrical element in order to ensure that the original intend at the time of the creation of the annotation is preserved; this avoids having an annotation that may be no more in contact with the selected geometrical element.

In examples, the creation of the annotation may automatically ensure that the annotation can be entirely read. In a first step, a determination is performed whether the annotation to be created (that is, during the process of creation) is partly or totally hidden in the at least one fixed view of the 3D modeled object. In a second step, if the determination is positive, then the annotation is displaced until the annotation is completely visible. The determination may be carried out using standard occlusion detection algorithm such as, but not limited to, Z-Buffer Algorithm, Ray tracing... The displacement may comprises automatically displacing the annotation or providing the user with one or more proposals of new locations of the annotation and selecting by the user one of these proposals.

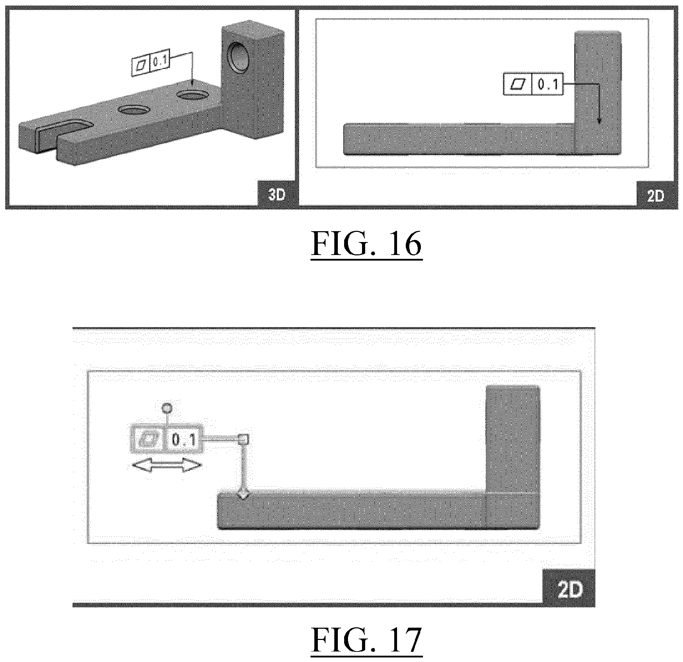

Referring to **FIG. 16****,** is represented an annotation whose creation has been performed in the orientation-free view (3D). In this view, and with the current viewpoint, the annotation is totally visible. However, the annotation is partially hidden in the default fixed view (2D). This being detected, the annotation may be displaced from the right to the left so that it is fully visible from the default fixed view (2D), as illustrated in **FIG. 17****.** In the example of **FIG. 17****,** the annotation has been automatically displaced from the right to the left side of the selected face the arrow of the annotation is pointing to. It is to be understood that the new position of the annotation might be given upon user action. Alternatively, the displacement of the annotation may comprise displacing parts of the annotation that are hidden; here the system might displace part of the arrow pointing to the 3D modeled object to the left while keeping the part of the annotation showing the textual information. This might also be performed upon user action, e.g. the user selects manipulator(s) of the arrow.

In example, the selecting a geometrical element for creating an annotation may comprise selecting at least two geometrical elements. The selection of at least two geometrical elements of the 3D modeled object may be used for certain types of annotations, e.g. for dimensions such as a distance between two geometrical elements. The selection of two or more geometrical element may be partially automated: after the selection of a first geometrical element, the system may determine a second geometrical element and select it automatically, e.g. a geometrical element of the same type with a same orientation ; being understood that the user can unselect the automatically selected geometrical element. For example, when the user selects a geometrical element that is a face, the system may automatically determine a second face that is parallel to the select face. The selection of two or more geometrical element may be performed upon action actions where the user selects the two faces. The system may know that two or more selections will be performed according to the selected type of annotation (if performed before the selection of the geometrical element). The selection of two or more geometrical elements may comprise informing the system that several geometrical elements will be selected, e.g. by using a haptic device such as a keyboard, so that the selection of the second geometrical element will not unselect the first selected geometrical element. After the selection of the two or more geometrical elements, and if an annotation type has been selected, the annotation is created. The examples previously discussed apply too.

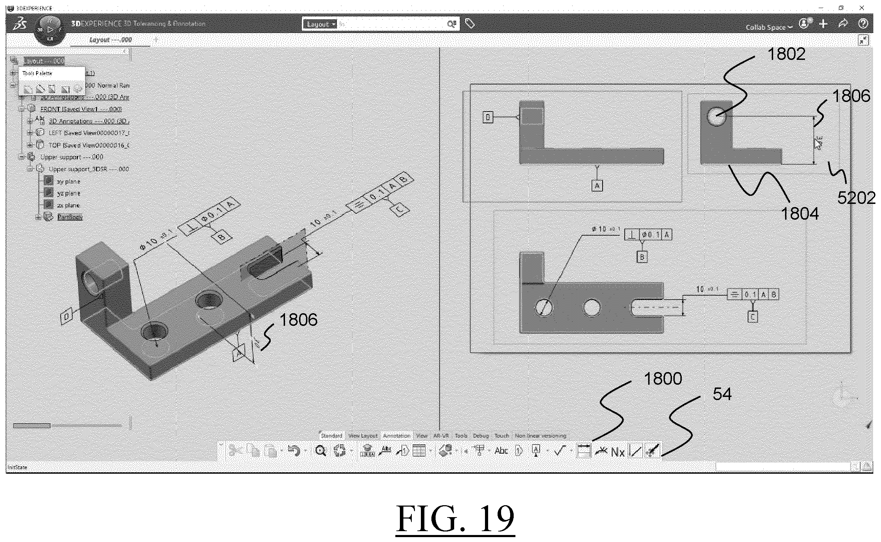

Referring now to **FIG. 19****,** is discussed an example where two geometrical elements are selected for creating an annotation of dimension type, e.g. a distance between two faces of the 3D modeled object. The user selects the annotation type "dimension" by clicking on the icon **1800** of the toolbar **54.** The system is thus aware that two or more geometrical element might be selected. In the example of **FIG. 19****,** the user has selected the geometrical element **1802,** which is a feature "hole", and the geometrical element **1804,** which is a face. The selection has been performed on the view **5202.** The annotation **1806** is created and displayed on the orientation-free view and on the fixed view on which the annotation. The orientation of the annotation 1806 is the same as in the view **5202.**

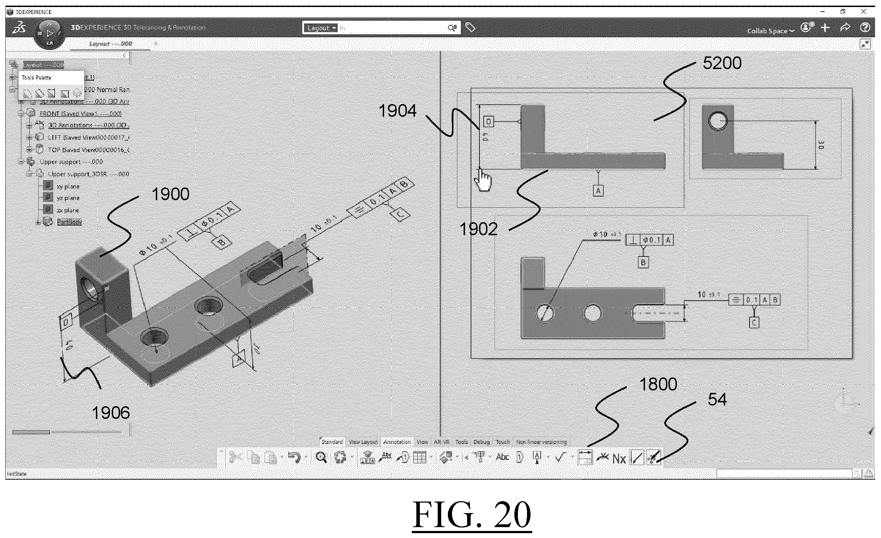

Referring now to **FIG. 20****,** is discussed another example where two geometrical elements are selected for creating an annotation of dimension type, e.g. a distance between two faces of the 3D modeled object. In this example, the user selects the geometrical element **1900** in the orientation-free view. Then he selects the geometrical element **1902** in the fixed view. The annotation type dimension **1800** is then selected via the toolbar **54,** and then the annotation can be created and displayed **1904, 1906.** In this example, the orientation of the annotation in the orientation-free view is the same as in the default fixed view **5200.**

As shown in these examples, the orientation of an annotation in the orientation-free view may be determined by the default fixed views at the time the annotation is created or the fixed view in which at least one selection of a geometrical element has been selected.

In examples, the number of displayed elements in the view(s) may be adapted by triggering a filtering to present a specific aspect of the part/product definition and associated specifications. Thus the filtering may concern the orientation-free view of the 3D modeled object and/or of the at least one fixed view of the 3D modeled object. The filtered element a part of the 3D modeled object representing the CAD assembly of parts, and/or a geometrical element of the 3D modeled object representing the CAD mechanical part, and/or a feature of the 3D modeled object representing the CAD mechanical part, and/or an annotation of a given annotation type previously created. The element to be filtered may selected on the 3D modeled object, e.g. upon user action. For example, if the user needs to filter annotation of the type "text", they can select one of the annotation of that type on one of the views, e.g. with the cursor, and select on the toolbar the function of filtering; or inversely, selecting the function on the toolbar first and then selecting the element to be filtered on one of the views.

Next, the filtered element(s) are made selectable for creating an annotation. For example, the filtered geometrical elements may be hole features that are, as a result of the filtering, made available for creating an annotation. In examples, the filtered elements may be highlighted in at least one of the views for a better identification by the user.

It has been discussed in reference to **FIG. 5** that a fixed view may be an isometric fixed view **5220** of the 3D modeled object. When there is a need to display more than one side of the annotated 3D modeled object, a fixed axonometric view can be used. By definition, an axonometric view may be an isometric or dimetric or trimetric view of the 3D modeled object. The axonometric fixed view may comprise a main support plane; for example the main support plane is defined by the plane on which the axonometric fixed view is represented. The main plane is typically parallel to the computer screen; that is, the main plane has the same orientation as the axonometric fixed view. The axonometric fixed view may further comprise one or more additional supports. Each of the main and additional supports can serve as a support for displaying an annotation.

In examples, the main and/or the additional supports may be graphically represented in the axonometric fixed view and/or in the orientation-free view. In an example, the main and/or the additional supports are represented in the axonometric fixed view and/or in the orientation-free view after a first user interaction, e.g. the user interacts with the axonometric fixed view. The graphical representation of the main and/or the additional supports may be removed after a second user interaction, e.g. with a fixed view other that the axonometric fixed view. The display and the removal of the display of the graphical representation of the main and/or the additional supports may be performed via the toolbar.

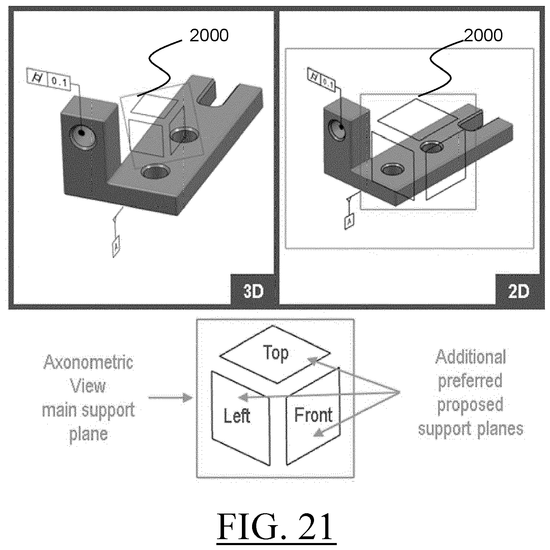

**FIG. 21** illustrates an example of the graphical representations of the main and the additional supports in the orientation-free view and the axonometric fixed view. In this example, the main support **2000** of the axonometric fixed view (2D) has the same orientation as the axonometric fixed view. The main support **2000** in the orientation-free view has the same orientation as in the axonometric fixed view. As the 3D model does not have the same orientation in the axonometric fixed view and in the orientation-free view, the main support **2000** in the orientation-free view is not parallel to the computer screen. In the example of **FIG. 21****,** three additional support are represented.

In the example of **FIG. 21****,** the supports are graphically represented by a squares, being understood that any other shape may be contemplated. The main support may be highlighted, e.g. represented with a different color; this improves the identification by the user of what support is the main support. Each of the additional supports has the same orientation as a computer fixed view. In this example, three fixed views have been previously computed, namely a front view, a top view and a left view.

When creating the annotation, one of the graphical representations (selected among) of the main and additional supports is selected, e.g. by the user; the support is selected. Then, an annotation is created, and the created annotation is displayed in a plane parallel to the selected support.

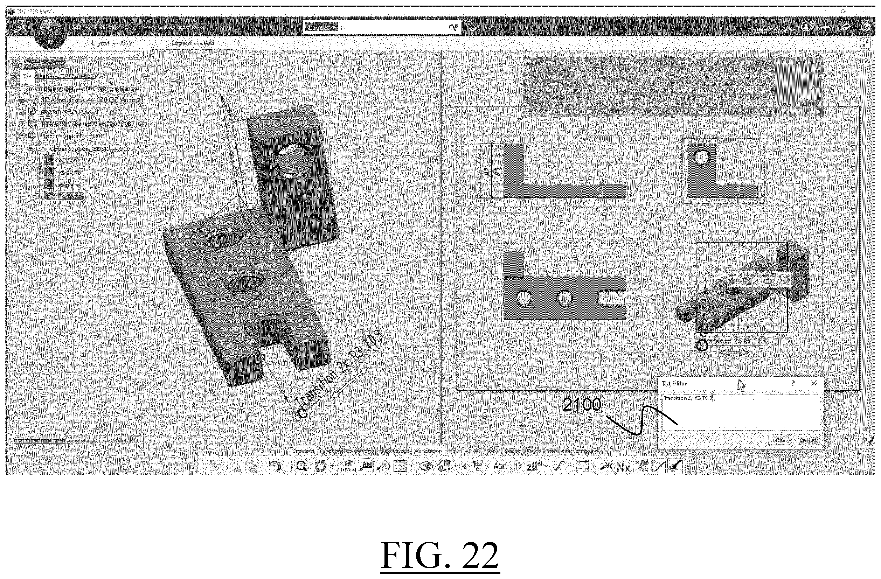

Referring now to **FIG. 22****,** an example of creating an annotation of an axonometric fixed view is now discussed. The user has performed the selection of geometrical element on the axonometric fixed view (2D). The selection has triggered the displaying of the graphical representation of the main support and three additional supports. Simultaneously, the selected geometrical element is also highlighted in the orientation-free view, and the graphical representation of the main support and three additional supports is shown too. The annotation type ("text" type) having been selected; the user can enter the text of the annotation, e.g. in the dialog box **2100.** As the user does not have selected an additional support, the main support is chosen by default and the annotation is represented on a plane that is parallel to the main support, as represented on the orientation-free view. The user can manipulate the annotation, e.g. a displacement of the textual zone on a surface defined by the main support. Once then final position of the annotation has been set, the user can click on the OK button of the dialog box **2100,** the creation of the annotation is finished. In the example of **FIG. 22****,** the axonometric view is not the default fixed view, but as the selection has been performed in the axonometric view, the annotation is placed in the 3D scene about the main view of the axonometric view - none of the additional supports has been selected in the course the creation of the annotation-.

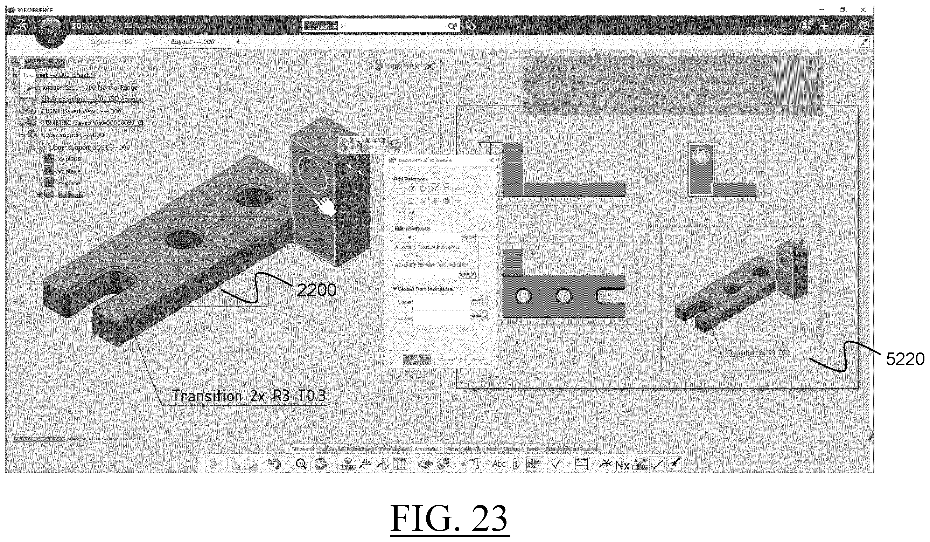

**FIG. 23** shows another example of creating an annotation using the graphical representations of the main and additional support. In this example, the axonometric view **5220** has been selected as default fixed view. The user has selected the annotation type "geometrical tolerance" and selected a geometrical element on the 3D modeled object represented on the orientation-free view ; the geometrical element is a feature "hole". The feature is highlighted in both orientation-free and fixed view. As the axonometric view is the default fixed view, the graphical representations of the main and additional supports are displayed; in this example, these graphical representations are displayed in the orientation-free view only as the selection of the geometric element has been done on the orientation-free view. It is to be understood that the graphical representations of the supports might be displayed on the both the orientation-free an axonometric fixed views. Once the graphical representations of the supports has been displayed on the orientation-free view, the user selects one of the supports. By default, the main support (here represented with a different color) is selected. In this example, the user has selected the support **2200;** the annotation will have the same orientation in the 3D scene as the selected support - here the additional support **2200-.** Still in the example of **FIG. 23****,** the selection of the geometric element also triggers the displaying of a menu for configuration the annotation to be created. When the annotation has been configured, the user can actuate the OK button of the contextual menu, thus confirming that the creation of the annotation is done; the created annotation is displayed on at least the orientation-free view (here on both views).

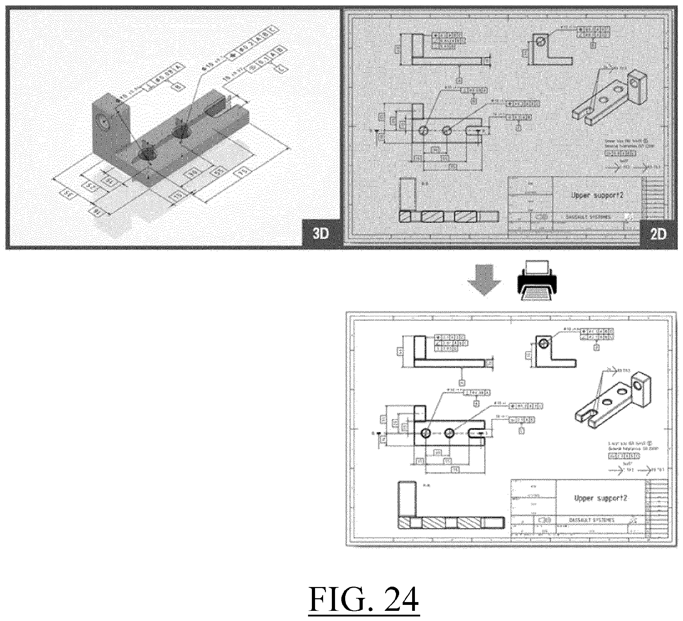

In examples, the user creates at least one annotation; if several annotations are added, the user repeats the creation as discussed herein above. With the creation of at least one annotation (e.g. the user has created the annotations needed for the manufacturing of the 3D modeled object), a 2D drawing compliant with a technical drawing can be generated. The generation is performed from one or more of the at least one fixed view of the 3D modeled object. As one single 3D modeled object has been annotated and the fixed views are views of this one single 3D modeled object, the generation of the 2D drawing compliant with a technical drawing can be directly generated from the fixed views. This principle is illustrated on FIG. 24. Interestingly, the multiple sheets display and layouted 2D multiple viewpoints allows a quick review of the technical drawing to be generated; this review can be easily done to check in one pass that any defined content is presented and presented correctly without ambiguity for perfect understanding.

In examples, the generation may comprise the computing a computer readable file for storing the one or more of the at least one fixed view of the 3D modeled object. The computer readable file may be of any file format; the file format may comprises a description of a flat document, e.g. a flat document to be printed on a paper sheet. In an example, the computer readable file may be a pdf (Portable Document Format), standardized a s ISO 32000. In example, the generation may comprise the printing of the one or more of the at least one fixed view of the 3D modeled object

Further examples of the method are now discussed.

In examples, the creating may comprise creating, upon user action, an annotation by selecting at least one geometrical element on the orientation-free view of the 3D modeled object and an annotation type. In this example, when creating from 3D, highlight of the selected geometrical element in the fixed views helps to confirm the best or required view presentation support plane. The user may decide to transfer the annotation at creation time into another fixed view among shown fixed view by selecting another fixed view as the active view. For example on **FIG. 25****,** the user has selected two geometrical elements, e.g. for creating an annotation of the type "dimension". The default fixed view **2500** provides the orientation of the annotation **2502;** the annotation has the same orientation in the 3D scene as the orientation of the fixed view **2500.** The user may select during the creation of the annotation another fixed view, e.g. **2504,** and as a result the orientation of the annotation is changed to the one of the newly selected fixed view **2504.** In this example, the view **2504** thus becomes the active view but the view **2500** may be kept as the default view; the next annotation will have by default the orientation of the default view **2500.**

Still in this example, the creation may end in a fixed view (e.g. a second selection of a geometrical element) to complete easily the acquisition; for example this avoids rotating the orientation-free view.

In examples, the user may inform the system that the creation has been done. For example, the creation of the annotation may comprise the displaying of a menu, as discussed in reference to **FIGs. 22** and **23****,** and the user interacts with the menu for confirming that the annotation can be created. More generally, the user can perform a user interaction on the GUI for informing the system that the creation has been done.

In examples, the selecting a geometrical element for creating the annotation may comprise highlighting the selected geometrical element. The highlighting may comprise, but is not limited to, rendering the selected geometrical element in a different way to unselected geometrical elements, e.g. a different color and/or texture, a different level of transparency, blinking its display... The highlighting may be performed for the view on which the selection has been performed, or for the view on which the selection has been performed and for the default view, or for the view on which the selection has been performed and for the active view, or for all views.

In examples, the views in the 3D scene are autonomous views. This means that the displaying of the views are independent and that modifications of one display only can be carried out. For example, the user may zoom/zoom out one views (e.g. the orientation-free view) while the level of zoom of the fixed view is unchanged. This involves that the user can displace a view from one sheet to another sheet and displace one view or one sheet from a first layout to a second layout.

## Claims

1. Computer-implemented method for annotating a 3D modeled object representing a CAD mechanical part or assembly of parts, two or more views of the 3D modeled object being displayed and at least one of the views being compliant with a view of a technical drawing, the method comprising:
- obtaining (S10 ) a 3D scene and displaying:
-- an orientation-free view of the 3D modeled object;
-- at least one fixed view of the 3D modeled object;
- creating (S20), upon user action, an annotation by selecting at least one geometrical element on at least one of the views of the 3D modeled object and an annotation type;
- displaying (S30) the created annotation on at least the orientation-free view.

2. The computer-implemented method of claim 1, further comprising:
- transferring the created annotation on at least one of the other views of the 3D modeled object.

3. The computer-implemented method of claim 2, wherein the displaying further comprises :
- displaying the annotation on the at least one of the other views of the 3D modeled object, the at least one of the other views of the 3D modeled object being a fixed view of the 3D modeled object, preferably the displaying the annotation on the at least one of the other views of the 3D modeled object and on the orientation-free view is simultaneously performed.

4. The computer-implemented method of any one of claim 1 to 3, wherein the creating the annotation comprises performing a first part of the user action in the orientation-free view and the second part of the user action in the at least one fixed view, each of the first and second parts of the user action being converted for the referential of the view on which the part of the user action is performed.

5. The computer-implemented method of any one of claims 1 to 4, wherein the displaying at least one fixed view of the 3D modeled object comprises:
- selecting a geometrical element on the orientation-free view of the 3D modeled; and
- computing at least one orthographic view of the 3D modeled object from the selected geometrical element.

6. The computer-implemented method of any one of claims 1 to 5, wherein the displaying at least one fixed view of the 3D modeled object further comprises:
- selecting a section line on one of the at least one fixed view of the 3D modeled object, the section line defining a cutting plane;
- computing and displaying a section view of the at least one fixed view of the 3D modeled object across the cutting plane.

7. The computer-implemented method of any one of claims 1 to 6, further comprising:
- filtering one or more elements of the orientation-free view of the 3D modeled object and/or of the at least one fixed view of the 3D modeled object, wherein the one or more elements are selected among:
- a part of the 3D modeled object representing the CAD assembly of parts;
- a geometrical element of the 3D modeled object representing the CAD mechanical part;
- a feature of the 3D modeled object representing the CAD mechanical part
- the annotation type of an annotation previously created;
- making the filtered one or more elements selectable for creating the annotation.

8. The computer-implemented method of any one of claims 1 to 7, wherein the at least one fixed view of the 3D modeled object comprises an axonometric fixed view of the 3D modeled object;
and wherein the creating an annotation further comprises:
- displaying a graphical representation of a main support of the axonometric fixed view and a graphical representation of at least additional support ;
- selecting one of the graphical representation;
wherein the displaying the created annotation further comprises displaying the annotation in plane parallel to the select support.

9. The computer-implemented method of any one of claims 1 to 8, wherein the creating the annotation further comprises:
- determining whether the annotation to be displayed is partly or totally hidden in the at least one fixed view of the 3D modeled object; and
- displacing the annotation to be displayed until the annotation to be displayed is completely visible.

10. The computer-implemented method of any one of claims 1 to 9, wherein the obtaining a 3D scene and displaying further comprises:
- displays a toolbar embedded in the 3D scene, the tool bar being usable for each of the views of the 3D scene, the tool bar allows toggling between a first, second and third working modes, where the first working mode comprises displaying the orientation-free view of the 3D modeled object alone, the second working mode comprises displaying the at least one fixed view of the 3D modeled object alone, the third working mode comprises displaying both the orientation-free view of the 3D modeled object and the at least one fixed view of the 3D modeled object.

11. The computer-implemented method of any one of claims 1 to 10, further comprising:
- generating a 2D drawing compliant with a technical drawing from one or more of the at least one fixed view of the 3D modeled object.

12. A computer program comprising instructions for performing the method of any of claims 1-11.

13. A computer readable storage medium having recorded thereon a computer program of claim 12.

14. A system comprising a processor coupled to a memory and a graphical user interface, the memory having recorded thereon the computer program of claim 12.
